## Europäisches Patentamt
## European Patent Office
## Office européen des brevets

(11) Veröffentlichungsnummer: **0 192 970 B1**

(12) **EUROPÄISCHE PATENTSCHRIFT**

(45) Veröffentlichungstag der Patentschrift: **20.03.91**

(51) Int. Cl.5: **H03F 3/56, H03F 1/30**

(21) Anmeldenummer: **86101009.8**

(22) Anmeldetag: **25.01.86**

(54) **Anordnung zur Verminderung der Brummstörung bei einem Klystron-Endverstärker.**

(30) Priorität: **26.02.85 DE 3506716**

(43) Veröffentlichungstag der Anmeldung:
**03.09.86 Patentblatt 86/36**

(45) Bekanntmachung des Hinweises auf die
Patenterteilung:
**20.03.91 Patentblatt 91/12**

(84) Benannte Vertragsstaaten:
**DE FR GB NL**

(56) Entgegenhaltungen:
US-A- 3 624 534
US-A- 3 848 197

PATENTS ABSTRACTS OF JAPAN, Band 6,
Nr. 103 (E-112) [981], 12. Juni 1982, Seite 11 E
112; & JP - A - 57 33 809 (MITSUBISHI DENKI
K.K.) 24.02.1982

MICROWAVES - PROCEEDINGS OF THE 4TH
INTERNATIONAL CONGRESS ON MICROWA-
VE TUBES, Scheveningen, 's-Gravenhage,
NL, 3. - 7. September 1962, Seiten 483-489,
Centrex Publishing Co., Eindhoven, NL; W.R.
CURTICE: "A method of noise reduction for
linear beam microwave devices of medium
power"

TELECOMMUNICATIONS & RADIO ENGINEE-
RING, Band 29/30, Nr. 9, September 1975,
Seiten 29-33, Washington, US; S.A. GONCHA-
ROV et al.: "A television transmitter for
bands IV and V with a power rating of 20/4
kW"

(73) Patentinhaber: **Licentia Patent-
Verwaltungs-GmbH
Theodor-Stern-Kai 1
W-6000 Frankfurt/Main 70(DE)**

(72) Erfinder: **Burwick, Karl, Dipl.-Ing.
Wutzkyallee 50
W-1000 Berlin 47(DE)**
Erfinder: **Volmering, Helmut, Ing.grad.
Urbanstrasse 93
W-1000 Berlin 61(DE)**

(74) Vertreter: **Vogl, Leo, Dipl.-Ing. et al
Licentia Patent-Verwaltungs-G.m.b.H.
Theodor-Stern-Kai 1
W-6000 Frankfurt 70(DE)**

# Beschreibung

Die Erfindung betrifft eine Anordnung nach dem Oberbegriff des Anspruchs 1.

Bei Klystron-Endverstärkern, wie sie insbesondere bei Fernseh-Bildsendern eingesetzt werden, tritt als Folge der Restwelligkeit der Klystron-Betriebsgleichspannung eine Brummstörung auf. Diese ist beim vom Fernsehsender abgegebenen Bildsignal störend und unerwünscht.

Es ist bekannt, die Betriebsgleichspannung des Klystrons sehr stark zu sieben. Die erforderlichen Siebmittel sind jedoch sehr teuer, außerdem ist ein erhöhter Aufwand nötig, um die Betriebsgleichspannung im Falle eines Überschlages im Klystron in hinreichend kurzer Zeit abschalten zu können.

Aus der US-A- 3 848 197 ist es bekannt, die Körperspannung eines Klystrons mit einer aufwendigen aktiven elektronischen Regelschaltung zu stabilisieren und zu entbrummen. Aus dem Dokument " Patent Abstracts of Japan ", Band 6 Nr. 103 (E 112), 12. Juni 1982, Seite 11E 112 wird allgemein ein Hochfrequenzverstärker erwähnt, bei dem der Treiber des Leistungsverstärkers nach Maßgabe der Betriebsspannung und des HF-Lastwiderstandes die Steuerleistung des Leistungsverstärkers so dosiert, daß der Leistungsverstärker nach nicht näher erläuterten Kriterien optimal arbeitet. Diese Lösung hat jedoch den Nachteil, bei einem Klystron-Verstärker nur Brummstörungen im Signalpegelbereich zu vermindern, nicht jedoch im Synchronpegelbereich.

Aufgabe der vorliegenden Erfindung ist es, bei einer Anordnung der eingangs genannten Art eine einfache wirtschaftlichere Möglichkeit zur Reduzierung der Brummstörung im Signalpegelbereich und Synchronpegelbereich anzugeben. Die Lösung dieser Aufgabe ist im Patentanspruch 1 gekennzeichnet. Die weiteren Ansprüche beinhalten vorteilhafte Ausgestaltungen der Erfindung.

Die Erfindung wird im folgenden anhand der Figur näher erläutert. Diese zeigt ein Ausführungsbeispiel der Erfindung, angewendet bei Fernseh-Bildsendern.

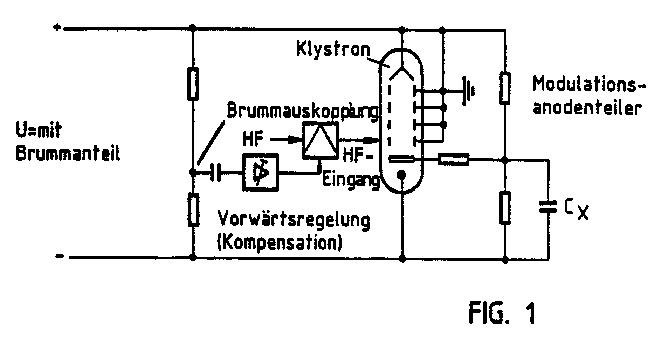

FIG. 1 zeigt ein Mehrkammer-Klystron mit der äußeren Beschaltung seiner Elektroden. Die Betriebsgleichspannung $U_=$ weist noch einen Brummanteil auf. Zwischen die Modulationsanode und -kathode des Klystrons ist ein vergleichsweise kleiner Siebkondensator $C_x$ (von größenordnungsmäßig 10 nF) geschaltet. Damit erfolgt eine Reduzierung der Brummstörungen der Modulationsanodenspannung, also auch eine Reduzierung von Brummstörungen des Klystron-Strahlstromes, der die Klystron-Sättigungsleistung bestimmt, und folglich eine Reduzierung von Brummstörungen im Synchronpegelbereich des zu übertragenden Fernsehsignals.

In der Äuführungsform nach Figur 1 werden die Brummstörungen im Signalpegelbereich des zu übertragenden Fernsehsignals ebenfalls vermindert. Aus der Betriebsgleichspannung $U_=$ ist durch Teilung eine die Brummstörung kompensierende Spannung abgeleitet und einem Stellglied (Brummauskopplung) zugeführt, welches im HF-Eingang des Klystrons liegt.

## Ansprüche

1. Anordnung zur Verminderung der Brummstörung bei einem Klystron-Endverstärker, bei der Siebmittel und/oder Kompensationsmittel in die Beschaltung des Klystrons eingefügt sind, **dadurch gekennzeichnet,** daß ein vergleichsweise kleiner Siebkondensator $(C_x)$ zwischen Modulationsanode und -kathode des Klystrons eingefügt ist, und daß eine die Brummstörung kompensierende bzw. gegenkoppelnde Spannung einem im trägerfrequenten Zug der Anordnung liegenden Stellglied zugeführt ist.

2. Anordnung nach Anspruch 1, **dadurch gekennzeichnet,** daß die Kapazität des Siebkondensators $(C_x)$ größenordnungsmäßig 10 nF beträgt.

3. Anordnung nach Anspruch 1, **dadurch gekennzeichnet,** daß die kompensierende Spannung durch Teilung aus der Betriebsgleichspannung gewonnen ist.

## Claims

1. Arrangment for reduction in the hum interference in a klystron output amplifier, in which filter means and/or compensating means are inserted into the wiring of the klystron, characterised thereby, that a comparatively small filter capacitor (Cx) is inserted between the modulation anode and the modulation cathode of the klystron and that a voltage compensating for or cancelling the hum interference is fed to a setting member lying in the carrier-frequency section of the arrangement.

2. Arrangement according to claim 1, characterised thereby, that the capacitance of-the filter capacitor (Cx) amounts in order of magnitude to 10 nanofarads.

3. Arrangement according to claim 1, characterised thereby, that the compensating voltage is obtained through division from the operating direct voltage.

## Revendications

1. Montage pour réduire le ronflement parasite dans un amplificateur d'étage final à klystron, dans le cas duquel des moyens de filtrage et/ou des moyens de compensation sont introduits dans les circuits du klystron, caractérisé par le fait qu'un condensateur de filtrage relativement petit ($C_X$) est introduit entre l'anode de modulation et la cathode de modulation du klystron et par le fait qu'une tension de compensation du ronflement parasite ou de contre-réaction est amenée à un organe de positionnement situé sur le conducteur à fréquence porteuse du montage.

2. Montage selon la revendication 1, caractérisé par le fait que la capacité du condensateur de filtration ($C_X$) est de l'ordre de grandeur de 10 nF.

3. Montage selon la revendication 1, caractérisé par le fait que l'on obtient la tension de compensation par division de la tension redressée d'exploitation.

FIG. 1